# EUROPEAN PATENT APPLICATION

(11) **EP 4 632 937 A1**
(43) Date of publication of application: **15.10.2025**
(21) Application number: 23900375.9
(22) Date of filing: 08.11.2023
(51) Int. Cl.: H01M 50/505, H01M 50/526, H01M 50/588, H01M 50/591

(54) **CONNECTION DEVICE AND BATTERY PACK**

(30) Priority: 05.12.2022 JP 2022194078
(71) Applicant: AESC Japan Ltd., Yokohama-Shi, Kanagawa 220-0012 (JP)
(72) Inventor: MATSUURA Moritaka, Zama-shi, Kanagawa 252-0012 (JP)
(74) Representative: Mathys & Squire
(86) International application number: PCT/JP2023/040196
(87) International publication number: WO 2024/122253

(57) **Abstract**

A connection device (200) includes a first bus bar (210) including a first insulating portion (212) covered with a first insulating coating film (212a) and a right exposure portion (216) exposed from the first insulating coating film (212a), a current sensor (240) through which the right exposure portion (216) of the first bus bar (210) passes, and a cover (250) covering at least a part of the right exposure portion (216) located between the first insulating portion (212) and the current sensor (240).

## Description

### TECHNICAL FIELD

The present invention relates to a connection device and a battery pack.

### BACKGROUND ART

In recent years, various battery packs have been developed. For example, Patent Document 1 describes a power supply structure including a current sensor. The power supply structure includes a bus bar having one end connected to a power post of a DC/DC converter. The bus bar is housed in a case made of insulating resin. Another end of the bus bar is exposed from the case and passes through an opening of the current sensor.

### RELATED DOCUMENT

### PATENT DOCUMENT

Patent Document 1: Japanese Patent Application Publication No. 2007-326496

### DISCLOSURE OF THE INVENTION

### TECHNICAL PROBLEM

In the structure described in Patent Document 1, for example, the bus bar and the current sensor are positioned such that a portion of the bus bar drawn from the opening of the current sensor is not exposed from the case near the current sensor. If the bus bar is displaced in a direction away from the opening of the current sensor, the portion of the bus bar drawn from the opening of the current sensor is exposed from the case near the current sensor. In this case, securing the electrical insulation of the bus bar may be difficult. The structure described in Patent Document 1, therefore, needs accurate positioning of the bus bar and the current sensor. To improve the assembly of the bus bar and the current sensor, however, the tolerance of the position of the bus bar and the position of the current sensor should be relatively great.

One example of the object of the present invention is to improve the assembly of the bus bar and the current sensor. Another object of the present invention will become apparent from the description of the present specification.

### SOLUTION TO PROBLEM

An aspect of the present invention is as follows.
[1] A connection device including:
   a bus bar including an insulating portion covered with an insulator and an exposure portion exposed from the insulator;
   a current sensor through which the exposure portion of the bus bar passes; and
   a cover covering at least a part of the exposure portion located between the insulating portion and the current sensor.
[2] The connection device according to [1], further including
   a placement portion on which the exposure portion is placed, in which
   the cover covers a portion of the exposure portion placed on the placement portion.
[3] The connection device according to [1] or [2], further including
   a support supporting the bus bar, in which
   the support has a structure for guiding a wiring electrically connected to the current sensor.
[4] A battery pack includes:
   the connection device according to any one of [1] to [3]; and
   a battery module electrically connected to the connection device.

### ADVANTAGEOUS EFFECTS OF INVENTION

According to the aspect described above of the present invention, the assembly of the bus bar and the current sensor can be improved.

### BRIEF DESCRIPTION OF THE DRAWINGS

[Fig. 1] A cross-sectional schematic diagram of a battery pack according to an embodiment.
[Fig. 2] A perspective view of a connection device according to the embodiment.
[Fig. 3] A perspective view of the connection device according to the embodiment with a cover removed.
[Fig. 4] A perspective view of the connection device according to the embodiment from a viewpoint from an opposite side of the viewpoint in Fig. 2.
[Fig. 5] A side view of the connection device according to the embodiment with a support and a wire harness removed.
[Fig. 6] A perspective view of a connection device according to a variant.

### DESCRIPTION OF EMBODIMENTS

Hereinafter, embodiments and variants of the present invention will be described by using drawings. In all the drawings, a similar component has a similar reference sign, and description thereof will be appropriately omitted.

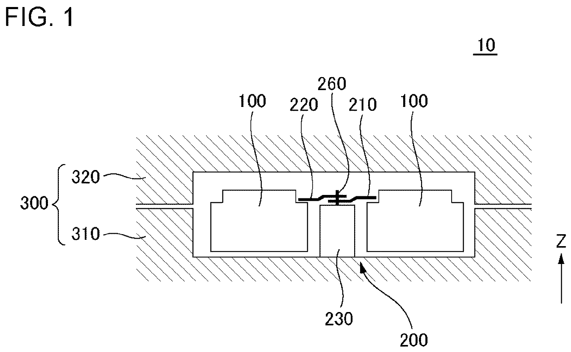

Fig. 1 is a cross-sectional schematic diagram of a battery pack 10 according to the embodiment. Fig. 1 illustrates a Z direction for description. The Z direction is a direction parallel to a vertical direction. The arrow indicating the Z direction indicates an upward direction.

The battery pack 10 is mounted on an automobile, for example. The use of the battery pack 10, however, is not limited to the automobile. The battery pack 10 includes a plurality of battery modules 100, a connection device 200, and a housing body 300. The housing body 300 includes a lower tray 310 and an upper cover 320. The plurality of battery modules 100 and the connection device 200 are housed in a housing space defined by the lower tray 310 and the upper cover 320.

Each of the battery modules 100 includes a plurality of battery cells. In one example, each of the battery cells includes a plurality of positive electrodes and a plurality of negative electrodes alternately laminated, a separator located between the adjacent positive electrode and the negative electrode, and an exterior body that seals the plurality of positive electrodes, the plurality of negative electrodes, and the separator. The structure of the battery cell, however, is not limited to this example. In one example, a plurality of cell groups including a plurality of battery cells connected in parallel is connected in series in the battery module 100. A plurality of single battery cells, however, may be connected in series. In the example illustrated in Fig. 1, the two battery modules 100 are directly connected via the connection device 200. As described below, the connection device 200 includes a first bus bar 210, a second bus bar 220, a support 230, and a fastener 260.

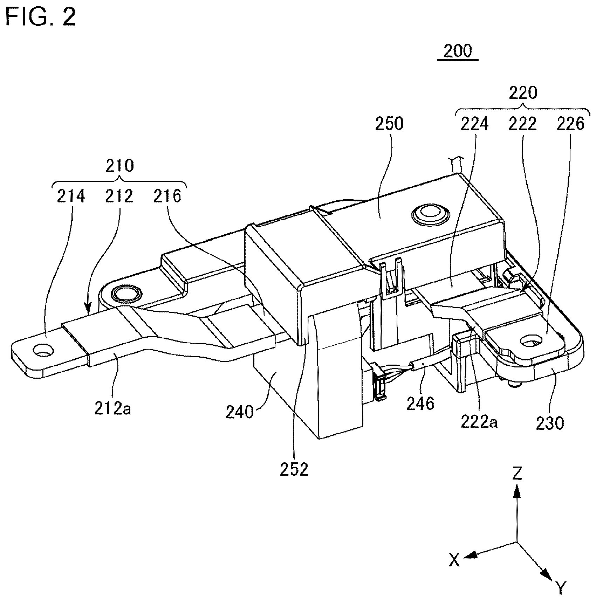

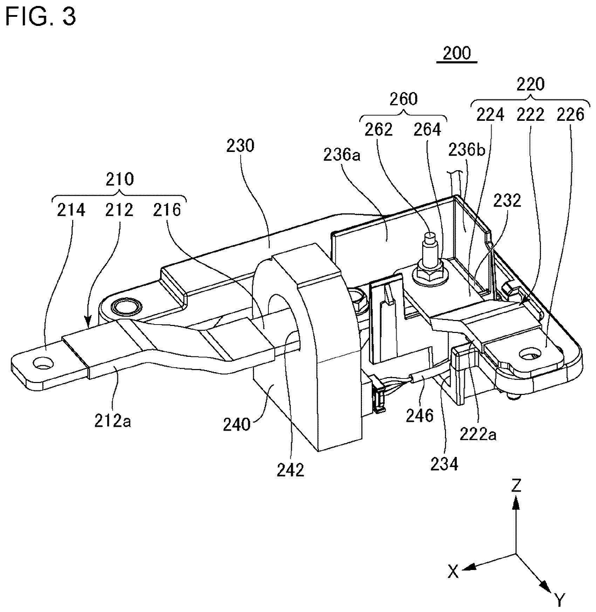

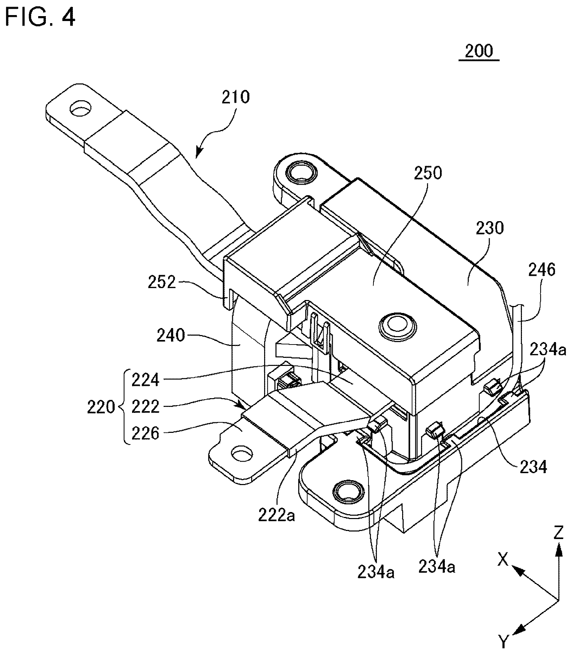

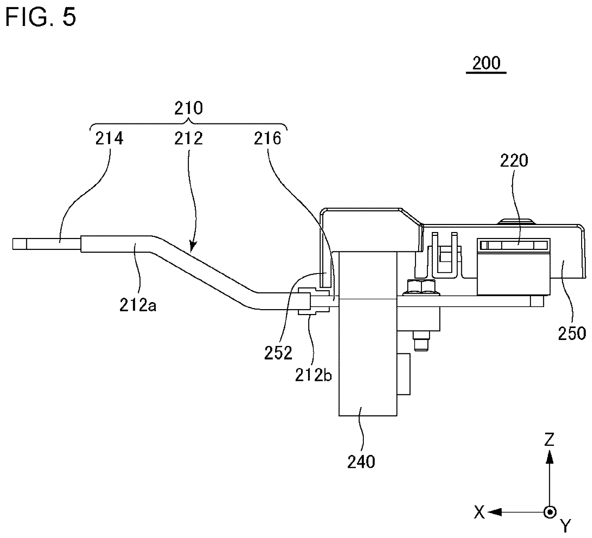

Fig. 2 is a perspective view of the connection device 200 according to the embodiment. Fig. 3 is a perspective view of the connection device 200 according to the embodiment with a cover 250 removed. Fig. 4 is a perspective view of the connection device 200 according to the embodiment from a viewpoint from an opposite side of the viewpoint in Fig. 2. Fig. 5 is a side view of the connection device 200 according to the embodiment with the support 230 and a wire harness 246 removed.

Figs. 2 to 5 illustrate an X direction, a Y direction, and the Z direction for description. In the embodiment, the X direction, the Y direction, and the Z direction are defined as follows for description. The Z direction is a direction parallel to the vertical direction. The X direction is one of horizontal directions perpendicular to the vertical direction. The Y direction is one of horizontal directions perpendicular to the vertical direction and the X direction. The arrow indicating the X direction, the arrow indicating the Y direction, and the arrow indicating the Z direction indicate a left direction, a front direction, and an upward direction, respectively. In Fig. 5, the white circle with the black dot indicating the Y direction indicates that the arrow indicating the Y direction extends from the rear to the front of a paper space. The relationship among the X direction, the Y direction, the Z direction, the left-right direction, the front-rear direction, and the up-down direction, however, is not limited to this example.

Hereinafter, a plane perpendicular to the Z direction is referred to as an XY plane as necessary. Hereinafter, a plane perpendicular to the X direction is referred to as a YZ plane as necessary. Hereinafter, a plane perpendicular to the Y direction is referred to as a ZX plane as necessary.

The connection device 200 includes the first bus bar 210, the second bus bar 220, the support 230, a current sensor 240, and the cover 250.

The first bus bar 210 extends substantially in parallel with the X direction as viewed from the Z direction. The first bus bar 210 is a conductor. The conductor is metal such as copper, for example. The first bus bar 210 includes a first insulating portion 212, a left exposure portion 214, and a right exposure portion 216.

The first insulating portion 212 is covered with a first insulating coating film 212a. The first insulating coating film 212a is an insulating sheet such as insulating resin, for example. The surface of the first bus bar 210 at the first insulating portion 212 is electrically insulated by the first insulating coating film 212a. The surface of the first insulating portion 212 may not be covered with the first insulating coating film 212a. The surface of the first insulating portion 212 may be subjected to insulation treatment by a method such as surface treatment, for example. In other words, the first insulating portion 212 may be covered with a predetermined insulator. A large current may flow through the first bus bar 210. In the embodiment, the first insulating portion 212 can secure the safety of the connection device 200 such as protecting the worker of the battery pack 10 from electric shock.

As illustrated in Figs. 2, 3, and 5, the left end portion and the right end portion of the first insulating portion 212 are bent with respect to a portion between the left end portion and the right end portion of the first insulating portion 212 as viewed from the Y direction. Specifically, the portion between the left end portion and the right end portion of the first insulating portion 212 is inclined downward from the left end portion toward the right end portion of the first insulating portion 212 as viewed from the Y direction. The left end portion and the right end portion of the first insulating portion 212 are substantially parallel to the X direction as viewed from the Y direction.

As illustrated in Figs. 2, 3, and 5, the left exposure portion 214 is exposed from the left end portion of the first insulating coating film 212a. The left exposure portion 214 protrudes toward the left from the left end portion of the first insulating coating film 212a. The left exposure portion 214 is substantially parallel to the XY plane. The right exposure portion 216 is exposed from the right end portion of the first insulating coating film 212a. The right exposure portion 216 protrudes toward the right from the right end portion of the first insulating coating film 212a. The right exposure portion 216 is substantially parallel to the XY plane. In the embodiment, the right exposure portion 216 is located at a position lower than the left exposure portion 214 in the Z direction.

The shape of the first bus bar 210 is not limited to the shape according to the embodiment. For example, the first insulating portion 212 may not be bent as viewed from the Y direction. In this case, the first bus bar 210 may extend substantially in parallel with the X direction between the left exposure portion 214 and the right exposure portion 216 as viewed from the Y direction.

The second bus bar 220 extends substantially in parallel with the Y direction as viewed from the Z direction. The second bus bar 220 is a conductor. The conductor is metal such as copper, for example. The second bus bar 220 includes a second insulating portion 222, a rear exposure portion 224, and a front exposure portion 226.

The second insulating portion 222 is covered with a second insulating coating film 222a. The second insulating coating film 222a is an insulating sheet such as insulating resin, for example. The surface of the second bus bar 220 at the second insulating portion 222 is electrically insulated by the second insulating coating film 222a. The surface of the second insulating portion 222 may not be covered with the second insulating coating film 222a. The surface of the second insulating portion 222 may be subjected to insulation treatment by a method such as surface treatment, for example. In other words, the second insulating portion 222 may be covered with a predetermined insulator. A large current may flow through the second bus bar 220. In the embodiment, the second insulating portion 222 can secure the safety of the connection device 200 such as protecting the worker of the battery pack 10 from electric shock.

As illustrated in Figs. 2 and 3, the front end portion of the second insulating portion 222 is bent with respect to the rear portion of the front end portion of the second insulating portion 222 as viewed from the X direction. Specifically, the rear portion of the front end portion of the second insulating portion 222 is inclined downward from the front end portion toward the rear end portion of the second insulating portion 222 as viewed from the X direction. The front end portion of the second insulating portion 222 is substantially parallel to the Y direction as viewed from the X direction.

As illustrated in Figs. 2 and 3, the rear exposure portion 224 is exposed from the rear end portion of the second insulating coating film 222a. The rear exposure portion 224 protrudes toward the rear from the rear end portion of the second insulating coating film 222a. The rear exposure portion 224 is substantially parallel to the XY plane. The front exposure portion 226 is exposed from the front end portion of the second insulating coating film 222a. The front exposure portion 226 protrudes toward the front from the front end portion of the second insulating coating film 222a. The front exposure portion 226 is substantially parallel to the XY plane. In the embodiment, the rear exposure portion 224 is located at a position lower than the front exposure portion 226 in the Z direction.

The shape of the second bus bar 220 is not limited to the shape according to the embodiment. For example, the second insulating portion 222 may not be bent as viewed from the X direction. In this case, the second bus bar 220 may extend substantially in parallel with the Y direction between the rear exposure portion 224 and the front exposure portion 226 as viewed from the X direction.

The support 230 is an insulator such as resin, for example. The support 230 integrally supports the first bus bar 210 and the second bus bar 220. Specifically, as illustrated in Fig. 3, the connected portion of the right end portion of the right exposure portion 216 and the rear end portion of the rear exposure portion 224 is placed on the upper surface of a placement portion 232 of the support 230. The right end portion of the right exposure portion 216 and the rear end portion of the rear exposure portion 224 overlap each other in the Z direction at the connected portion of the right end portion of the right exposure portion 216 and the rear end portion of the rear exposure portion 224. In the example illustrated in Fig. 3, the rear end portion of the rear exposure portion 224 is disposed above the right end portion of the right exposure portion 216. The right end portion of the right exposure portion 216, however, may be disposed above the rear end portion of the rear exposure portion 224. The connected portion of the right end portion of the right exposure portion 216 and the rear end portion of the rear exposure portion 224 is integrally fastened to the placement portion 232 by the fastener 260. The strength of the overlapping portion of the rear exposure portion 216 and the rear exposure portion 224 of the first bus bar 210 and the second bus bar 220 can be reinforced accordingly.

In the example illustrated in Fig. 3, the fastener 260 includes a bolt 262 and a nut 264. The bolt 262 extends through the connected portion of the right end portion of the right exposure portion 216 and the rear end portion of the rear exposure portion 224 from below substantially in parallel with the Z direction. The nut 264 is disposed above the connected portion of the right end portion of the right exposure portion 216 and the rear end portion of the rear exposure portion 224. The connected portion of the right end portion of the right exposure portion 216 and the rear end portion of the rear exposure portion 224 is integrally fastened to the placement portion 232 by tightening the bolt 262 to the nut 264. The right end portion of the right exposure portion 216 and the rear end portion of the rear exposure portion 224 may be electrically connected to each other via the bolt 262. The structure for integrally fastening the connected portion of the right end portion of the right exposure portion 216 and the rear end portion of the rear exposure portion 224 to the placement portion 232, however, is not limited to this example.

The left exposure portion 214 is electrically connected to a predetermined battery module 100 not illustrated in Figs. 2 to 5. The front exposure portion 226 is electrically connected to another predetermined battery module 100 not illustrated in Figs. 2 to 5. As a result, the predetermined battery module 100 and the other predetermined battery module 100 can be electrically connected to each other via the first bus bar 210 and the second bus bar 220.

In the embodiment, the first bus bar 210 and the second bus bar 220 are separatable. Accordingly, the first bus bar 210 can be exchanged according to a kind of the battery module 100 electrically connected to the first bus bar 210. Similarly, the second bus bar 220 can be exchanged according to a kind of the battery module 100 electrically connected to the second bus bar 220. As a result, an appropriate bus bar can be easily selected according to a kind of the battery module 100 electrically connected to the bus bar as compared to the case where the first bus bar 210 and the second bus bar 220 are an integral bus bar having substantially an L shape as viewed from the Z direction. The first bus bar 210 and the second bus bar 220, however, may be an integral bus bar having substantially an L shape as viewed from the Z direction.

The current sensor 240 is disposed on the left of the placement portion 232. As illustrated in Fig. 3, the right exposure portion 216 passes through an opening 242 of the current sensor 240 substantially in parallel with the X direction. The current sensor 240 detects a magnetic field generated around the right exposure portion 216 in the X direction. By the detection of the magnetic field, the current sensor 240 detects a current flowing through the first bus bar 210.

In one example, the position of the current sensor 240 with respect to the first bus bar 210 can be fixed by fixing the current sensor 240 and the right exposure portion 216 to each other. The method of fixing the position of the current sensor 240 with respect to the first bus bar 210, however, is not limited to this example.

The wire harness 246 is electrically connected to the current sensor 240. The wire harness 246 is a wiring for supplying a signal and power to the current sensor 240. The wire harness 246 is routed toward the outside of the support 230 via a groove 234 provided in the support 230. In other words, the groove 234 constitutes at least a part of a structure for guiding the wire harness 246. In the embodiment, the movement of the wire harness 246 due to a factor such as the impact can be regulated as compared to the case where the wire harness 246 is not guided by the groove 234. As a result, the breakage of the wire harness 246 due to interference of the wire harness 246 with the first bus bar 210, the second bus bar 220, and the support 230, and the short circuit of the wire harness 246 with the first bus bar 210 and the second bus bar 220 can be suppressed as compared to the case where the wire harness 246 is not guided by the groove 234.

As illustrated in Figs. 3 and 4, the groove 234 includes a portion extending substantially in parallel with the X direction in a portion of the support 230 located below the second bus bar 220, and a portion extending substantially in parallel with the Y direction in a portion of the support 230 located on the right of the placement portion 232. As a result, the wire harness 246 can be routed in the portion of the groove 234 located below the second bus bar 220. The second bus bar 220 and the wire harness 246, therefore, can cross each other as viewed from the Z direction.

In the embodiment, as illustrated in Fig. 4, a pair of catches 234a is provided at a plurality of places of the groove 234. The pair of catches 234a can restrain the wire harness 246 from escaping toward the above of the groove 234. These catches 234a, however, may not be provided.

The cover 250 is an insulator such as resin, for example. As illustrated in Figs. 2, 4, and 5, the right portion of the cover 250 covers the connected portion of the right exposure portion 216 and the rear exposure portion 224 from above. As a result, the worker's finger of the battery pack 10 can be less likely to touch the upper portion of the connected portion of the right exposure portion 216 and the rear exposure portion 224. The connected portion of the right exposure portion 216 and the rear exposure portion 224 can be also protected from foreign matter or an impact from above. The left portion of the cover 250 covers the current sensor 240 from above. As a result, the current sensor 240 can be protected from foreign matter or an impact from above.

As illustrated in Fig. 3, the support 230 is provided with a rear partition wall 236a and a right partition wall 236b. The rear partition wall 236a and the right partition wall 236b are orthogonal substantially in an L shape as viewed from the Z direction. The rear partition wall 236a and the right partition wall 236b, however, may not be provided. The rear partition wall 236a is disposed on the rear of the connected portion of the right exposure portion 216 and the rear exposure portion 224. As a result, the worker's finger of the battery pack 10 can be less likely to touch the rear portion of the connected portion of the right exposure portion 216 and the rear exposure portion 224. The connected portion of the right exposure portion 216 and the rear exposure portion 224 can be also protected from foreign matter or an impact from the rear. The right partition wall 236b is disposed on the right of the connected portion of the right exposure portion 216 and the rear exposure portion 224. As a result, the worker's finger of the battery pack 10 can be less likely to touch the right portion of the connected portion of the right exposure portion 216 and the rear exposure portion 224. The connected portion of the right exposure portion 216 and the rear exposure portion 224 can be also protected from foreign matter or an impact from the right.

As illustrated in Figs. 2, 4, and 5, a protrusion 252 protrudes downward from the left end portion of the cover 250. The right side surface portion of the protrusion 252 covers the upper end portion of the left side surface of the current sensor 240. As a result, the upper end portion of the current sensor 240 can be protected from foreign matter or an impact from the left. The lower end portion of the protrusion 252 covers a portion of the right exposure portion 216 located between the right end portion of the first insulating portion 212 and the left end portion of the current sensor 240. As a result, the worker's finger of the battery pack 10 can be less likely to touch the upper surface of the portion of the right exposure portion 216. The portion of the right exposure portion 216 can be also protected from foreign matter or an impact from above.

Hereinafter, the portion of the right exposure portion 216 located between the right end portion of the first insulating portion 212 and the left end portion of the current sensor 240 is referred to as a left portion of the right exposure portion 216 as necessary.

In the embodiment, even if the left portion of the right exposure portion 216 is displaced to the left side, the lower end portion of the protrusion 252 can cover the left portion of the right exposure portion 216. As a result, the electrical insulation of the first bus bar 210 can be secured as compared to the case where the left portion of the right exposure portion 216 is not covered with the lower end portion of the protrusion 252. In other words, the tolerance of the displacement of the position of the left portion of the right exposure portion 216 to the left side can be increased as compared to the case where the protrusion 252 is not provided. The assembly of the first bus bar 210 and the current sensor 240 can be therefore improved as compared to the case where the protrusion 252 is not provided.

In the embodiment, even if the left portion of the right exposure portion 216 is displaced to the right side by the length in the X direction of the left portion of the right exposure portion 216, the first insulating portion 212 does not enter the opening 242 of the current sensor 240. As a result, the current sensor 240 can accurately detect a current flowing through the first bus bar 210 as compared to the case where a part of the first insulating portion 212 enters the opening 242 of the current sensor 240. In other words, the tolerance of the displacement of the position of the portion of the right exposure portion 216 to the right side can be increased as compared to the case where the protrusion 252 is not provided. The assembly of the first bus bar 210 and the current sensor 240 can be therefore improved as compared to the case where the protrusion 252 is not provided.

As illustrated in Fig. 5, an insulating fixing material 212b may be provided on the right end portion of the first insulating coating film 212a. The insulating fixing material 212b fixes the first insulating coating film 212a to the first bus bar 210. The insulating fixing material 212b is an insulating tape, for example. The insulating fixing material 212b, however, may not be provided. As illustrated in Fig. 5, the insulating fixing material 212b may cover at least a part of the left portion of the right exposure portion 216. In this case, the worker's finger of the battery pack 10 can be less likely to touch the left portion of the right exposure portion 216 as compared to the case where the insulating fixing material 212b is not provided. As illustrated in Fig. 5, the right end portion of the insulating fixing material 212b may be displaced to the left side with respect to the left side surface of the current sensor 240. In this case, the insulating fixing material 212b can be less likely to enter the opening 242 of the current sensor 240 due to the tolerance as compared to the case where the position of the right end portion of the insulating fixing material 212b and the position of the left side surface of the current sensor 240 are aligned in the X direction.

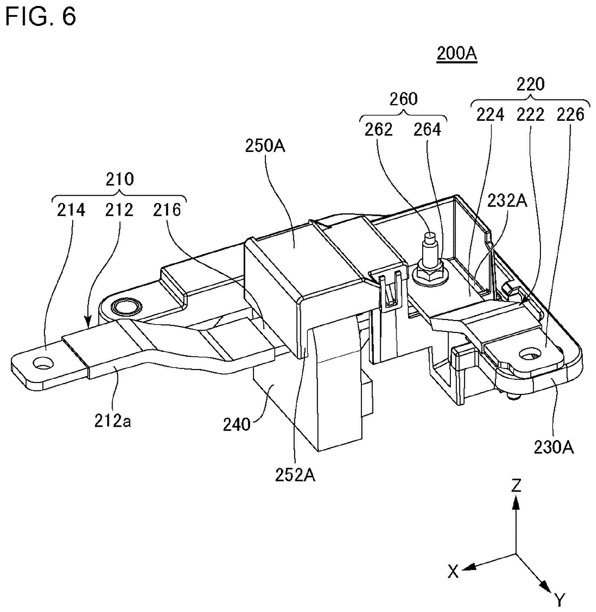

Fig. 6 is a perspective view of a connection device 200A according to a variant. The connection device 200A according to the variant is the same as the connection device 200 according to the embodiment except for the following points. Fig. 6 does not illustrate a wire harness electrically connected to the current sensor 240 for simplifying description.

The connection device 200A according to the variant includes a cover 250A. The cover 250A according to the variant covers the current sensor 240 from above. The cover 250A, however, exposes the connected portion of the right exposure portion 216 and the rear exposure portion 224 on the upper surface side of the placement portion 232A of the support 230A. In the variant, the cost of the cover 250A can be reduced by an amount of which the cover 250A does not cover the connected portion of the right exposure portion 216 and the rear exposure portion 224.

The cover 250A according to the variant includes a protrusion 252A, as does the cover 250 according to the embodiment. The lower end portion of the protrusion 252A according to the variant covers the left portion of the right exposure portion 216, as does the lower end portion of the protrusion 252 according to the embodiment. In the variant, therefore, the assembly of the first bus bar 210 and the current sensor 240 can be also improved as compared to the case where the protrusion 252A is not provided.

While the embodiments and the variants of the present invention have been described with reference to the drawings, these are only exemplification of the present invention, and various configurations other than the embodiments and variants described above can also be employed.

This application claims priority based on Japanese patent application No. 2022-194078, filed on December 5, 2022, the disclosure of which is incorporated herein in its entirety by reference.

### REFERENCE SIGNS LIST

10 Battery pack, 100 Battery module, 200, 200A Connection device, 210 First bus bar, 212 First insulating portion, 212a First insulating coating film, 212b Insulating fixing member, 214 Left exposure portion, 216 Right exposure portion, 220 Second bus bar, 222 Second insulating portion, 222a Second insulating coating film, 224 Rear exposure portion, 226 Front exposure portion, 230, 230A Support, 232, 232A Placement portion, 234 Groove, 234a Catch, 236a Rear partition wall, 236b Right partition wall, 240 Current sensor, 242 Opening, 246 Wire harness, 250, 250A Cover, 252, 252A Protrusion, 260 Fastener, 262 Bolt, 264 Nut, 300 Housing body, 301 Lower tray, 320 Upper cover

## Claims

1. A connection device comprising:
a bus bar including an insulating portion covered with an insulator and an exposure portion exposed from the insulator;
a current sensor through which the exposure portion of the bus bar passes; and
a cover covering at least a part of the exposure portion located between the insulating portion and the current sensor.

2. The connection device according to claim 1, further comprising
a placement portion on which the exposure portion is placed, wherein
the cover covers a portion of the exposure portion placed on the placement portion.

3. The connection device according to claim 1 or 2, further comprising
a support supporting the bus bar, wherein
the support has a structure for guiding a wiring electrically connected to the current sensor.

4. A battery pack comprising:
the connection device according to claim 1 or 2; and
a battery module electrically connected to the connection device.
